(19) Europäisches Patentamt
European Patent Office
Office européen des brevets

(11) EP 4 223 830 A1

(12) EUROPEAN PATENT APPLICATION
published in accordance with Art. 153(4) EPC

(43) Date of publication:
09.08.2023 Bulletin 2023/32

(21) Application number: 21875318.4

(22) Date of filing: 21.09.2021

(51) International Patent Classification (IPC):
*C08J 5/18* (2006.01) *H01Q 1/38* (2006.01)
*H05K 1/03* (2006.01)

(52) Cooperative Patent Classification (CPC):
C08J 5/18; H01Q 1/38; H05K 1/03

(86) International application number:
PCT/JP2021/034504

(87) International publication number:
WO 2022/071016 (07.04.2022 Gazette 2022/14)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 29.09.2020 JP 2020163370
29.03.2021 JP 2021054809

(71) Applicant: **Toray Industries, Inc.**
**Tokyo 103-8666 (JP)**

(72) Inventors:
- **TAKAHASHI, Kenta**
  **Otsu-shi, Shiga 520-8558 (JP)**
- **HAMASAKI, Risa**
  **Otsu-shi, Shiga 520-8558 (JP)**
- **MAEKAWA, Shigetoshi**
  **Otsu-shi, Shiga 520-8558 (JP)**

(74) Representative: **Kador & Partner Part mbB**
**Corneliusstraße 15**
**80469 München (DE)**

# (54) POLYARYLENE SULFIDE FILM

(57) The present invention provides a polyarylene sulfide film having excellent transparency and color tone. The present invention is a polyarylene sulfide film which contains, as a main component, a polyarylene sulfide (PAS)-based resin, has a spectral light transmittance Ta at a wavelength of 550 nm of at least 75% and has a b value of at most 5.0.

EP 4 223 830 A1

## Description

TECHNICAL FIELD

The present invention relates to a polyarylene sulfide film.

BACKGROUND ART

In recent years, studies on glass have been advanced for circuit board materials that require transparency. Glass substrates have, however, drawbacks such as being easily broken, heavy, and difficult to be thinned, and have failed to have any adequate material for making the glass substrates flexible to windshields of vehicles or parts in contact with curved surfaces indoors or outdoors.

Polyarylene sulfide resins have properties such as excellent heat resistance, flame retardancy, rigidity, chemical resistance, electrical insulation, and low hygroscopicity, and have been suitably used particularly for electric and electronic devices, machine parts, automobile parts, and the like. Materials that are small in transmission loss are required from the trend of increasing the speed and the capacity in the fields of electric and electronic parts, and polyarylene sulfide films typified by polyphenylene sulfide (hereinafter, abbreviated as a PPS in some cases) films have been increasingly applied to circuit materials by taking advantage of the transmission loss and the low hygroscopicity. The PPS films are, however, low in transparency and inferior in color tone, thus, for example, when the PPS film is used as a transparent circuit substrate, the PPS film is likely to cause the visibility to be deteriorated due to factors of transparency and color tone, and improvements in transparency and color tone have been desired.

For PPS films, techniques for improving the color tones have not been sufficiently studied so far. For example, a technique for a PPS film subjected to a rubbing treatment is disclosed as a technique for improvements in transparency and slippage (Patent Document 1). In addition, a technique for reducing the content of impurities by-produced during the polymerization reaction to improve the volatile content and the color tone is disclosed (Patent Document 2).

PRIOR ART DOCUMENTS

PATENT DOCUMENTS

Patent Document 1: Japanese Patent Laid-open Publication No. 2013-67748
Patent Document 2: Japanese Patent Laid-open Publication No. 2009-138206

SUMMARY OF THE INVENTION

PROBLEMS TO BE SOLVED BY THE INVENTION

The technique described in Patent Document 1 has, however, the problem of being insufficient for improving the color tone of the PPS resin. In addition, the technique described in Patent Document 2 has the problem of being insufficient in transparency in the case of film applications.

It is an object of the present invention to solve the above-mentioned problems. More specifically, it is intended to provide a polyarylene sulfide film that is excellent in transparency and color tone.

SOLUTIONS TO THE PROBLEMS

In order to solve the above-mentioned problems, a polyarylene sulfide film according to the present invention has the following configuration. More specifically, the polyarylene sulfide film is a polyarylene sulfide film that contains a polyarylene sulfide (PAS) based resin as a main component, and has a spectral light transmittance Ta of 75% or more at a wavelength of 550 nm and a b value of 5.0 or less.

EFFECTS OF THE INVENTION

The polyarylene sulfide film according to the present invention is excellent in transparency and color tone. Accordingly, advantage of such characteristics can be taken to use the polyarylene sulfide film suitably as various parts that require, in particular, the transparency of an automobile member, a battery member, a display member, an industrial packaging material, a design material, and an electric/electronic material, for example, a transparent circuit substrate,

a transparent antenna substrate, a highfrequency transparent circuit substrate, and a highfrequency transparent antenna substrate.

EMBODIMENTS OF THE INVENTION

In the present invention, the polyarylene sulfide film is a film obtained by melt-molding a resin composition containing a polyarylene sulfide (PAS) based resin as a main component into a sheet, which may be preferably biaxially stretched and heat-treated.

In the present invention, containing the PAS-based resin as a main component refers to containing the PAS-based resin at 50% by mass or more, preferably 60% by mass or more, more preferably 70% by mass or more. If the content of the PAS-based resin is less than 50% by mass, the heat resistance, dimensional stability, and mechanical properties, which are characteristics of the PAS film, may be impaired.

The PAS-based resin for use in the present invention is a copolymer that has a repeating unit of -(Ar-S)-. Examples of Ar include units represented by the following formulas (A) to (K).

[Chemical formula 1]

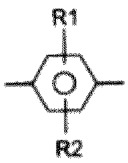
...(A)

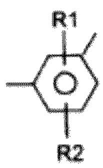
...(B)

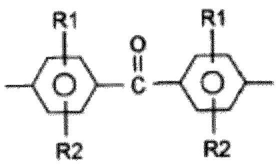
...(C)

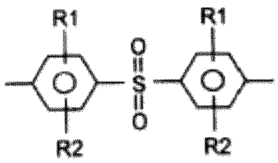
...(D)

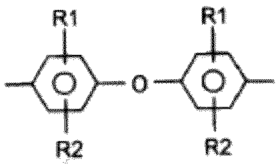
...(E)

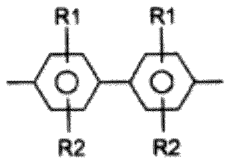
...(F)

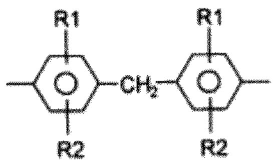
...(G)

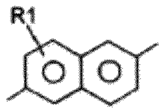
...(H)

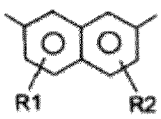
...(I)

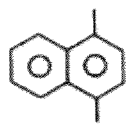
...(J)

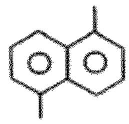
...(K)

(R1 and R2 are substituents selected from hydrogen, an alkyl group, an alkoxy group, and a halogen group, and R1 and R2 may be identical or different.)

The repeating unit is, among the foregoing formulas, preferably a p-arylene sulfide unit. Representative examples thereof include a polyphenylene sulfide, a polysulfone, a polyether sulfone, a polyphenylene sulfide sulfone, and a polyphenylene sulfide ketone, and examples of the particularly preferred p-arylene sulfide unit include a p-phenylene sulfide unit from the viewpoints of film properties and economic efficiency.

The polyarylene sulfide-based resin for use in the present invention is preferably composed of a p-phenylene sulfide unit represented by the following structural formula as a main component unit at 80 mol% or more and 99.9 mol% or less of all of the repeating units. The PAS-based resin for use in the present invention has the composition mentioned above, thereby allowing excellent heat resistance and chemical resistance to be exhibited.

[Chemical formula 2]

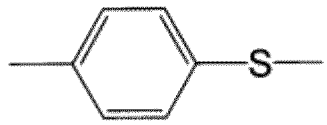

In addition, the PAS-based resin for use in the present invention can also be copolymerized with a copolymerization unit in the range of 0.01 mol% or more and 20 mol% or less of the repeating units.

Preferred copolymerization units include the following, and a particularly preferred copolymerization unit is an m-phenylene sulfide unit.

[Chemical formula 3]

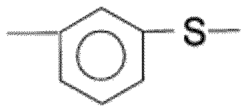

[Chemical formula 4]

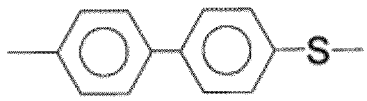

[Chemical formula 5]

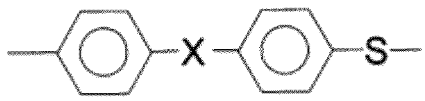

(where X represents an alkylene, CO, or $SO_2$ unit.)

[Chemical formula 6]

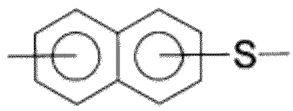

[Chemical formula 7]

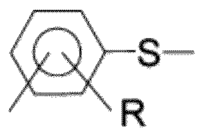

(where R represents an alkyl, nitro, phenylene, or alkoxy group.)

In the main constituent unit of the PAS-based resin for use in the present invention, the aspect of the copolymerization with the copolymerization unit is not particularly limited, but a random copolymer is preferred.

The PAS-based resin composition constituting the PAS film according to the present invention may contain

therein, as long as the effects of the present invention are not impaired, various additives such as an antioxidant, a heat stabilizer, an antistatic agent, and an antiblocking agent.

The PAS film according to the present invention is required to have a light transmittance (Ta) of 75% or more at a wavelength of 550 nm. Ta is 75% or more, thereby providing a film that is excellent in transparency. If Ta is less than 75%, the turbidity of the film may be increased, and the transparency may be degraded in the case of using the film as a transparent circuit substrate or a protective substrate for an optical member. The light transmittance at the wavelength of 550 nm is more preferably 78% or more, still more preferably 80% or more. Examples of the approach for setting the light transmittance at the wavelength of 550 nm within the range mentioned above include an approach for controlling the particles or other resin contained in the film for running performance described later, and a method for applying a washing treatment with a solvent to the polymer or obtained film after polymerization described later to remove impurities.

For the PAS film according to the present invention, the light transmittance (Tb) at a wavelength of 400 nm and the light transmittance (Tc) at a wavelength of 600 nm preferably satisfy the following formula (i).

$$Tc - Tb \leq 8.2\% \quad \text{Formula (i).}$$

Having the characteristics mentioned above refers to fewer impurities that absorb light in the wavelength range from 400 nm to 600 nm, thereby providing a less colored film. In addition, if Tc - Tb exceeds 8.2%, the film may have coloring and undergo a decrease in color tone in the case of use as a substrate material. More preferably, the light transmittances meet Tc - Tb ≤ 8.0%. The Tc - Tb can be controlled to fall within the range mentioned above by reducing impurities remaining in the PAS film in accordance with a washing treatment described later. In the present invention, the impurities refer to substances that absorb light in the range of 400 to 600 nm, such as an N-methyl-2-pyrrolidone (NMP) as a polymerization solvent, a sodium hydrogen sulfide (NaSH) as a by-product at the time of polymerization, and a 4-chlorobenzenethiolate. The light transmittances at the wavelengths of 550 nm, 400 nm, and 600 nm can be evaluated by an approach described later.

The PAS film according to the present invention is required to have a b value, which is an index of yellowness, of 5.0 or less. The b value is 5.0 or less, thereby providing a film that is excellent in color. If the b value exceeds 5.0, the visibility may be deteriorated due to a factor of color tone in the case of use as a transparent circuit substrate or a protective substrate for an optical member, thereby overlooking defects. The b value is more preferably 3.0 or less, still more preferably 2.5 or less, most preferably 2.0 or less. The lower limit is not to be considered particularly limited, but is preferably 0.0 or more from the viewpoint of productivity. Examples of the method for obtaining a polyarylene sulfide film that has a b value within the range mentioned above include a method for applying a washing treatment with a solvent to a polymer or an obtained film after polymerization as described later to remove impurities.

The PAS film according to the present invention preferably has an L value, which is an index of lightness, of 85 or more. The L value is set to fall within the range mentioned above, thereby providing a film that is excellent in color tone. If the L value is less than 85, the visibility may be deteriorated with low lightness, in the case of use as a transparent circuit substrate or a protective substrate for an optical member. The L value is more preferably 90 or more. In order to obtain a PAS film that has an L value in the range mentioned above, the L value can be controlled with the particles or other resin contained in the film described later, and controlled with the laminated configuration of the film described later. The L value can be evaluated by an approach described later.

The washing treatment in the present invention is a step of immersing, in a solvent, a polymer powder after polymerization or a film obtained by melt-molding a polymer into a sheet and subjecting the sheet to a biaxial-stretching heat treatment, while heating the film for a predetermined time. In the present invention, examples for the polymer powder include, but are not particularly limited to, a method of reacting an alkali metal sulfide such as a sodium sulfide and a polyhaloaromatic compound such as a p-dichlorobenzene in an organic amide solvent such as an NMP (Japanese Patent Laid-open Publication No. 45-3368 B). In particular, a method of washing, with a solvent, a polymer powder obtained by polymerization is preferred from the viewpoint of productivity and efficiency.

Examples of the washing solvent for use in the washing treatment include an acetone, a toluene, and an NMP, the washing solvent is used, in particular, for a polymerization solvent, and an NMP is preferred from the viewpoint of removing the remaining impurities.

Next, the present invention will be described with reference to, as an example, a washing method with an NMP used, but the present invention is not construed as being limited thereto.

In the present invention, the temperature of the solvent for the washing is preferably 100°C or higher and 200°C or lower. The temperature for the washing is set to fall within the range mentioned above, which is equal to or higher than the glass transition temperature of the resin, thereby starting molecular chain motions, and thus allowing the remaining impurities to be efficiently removed, and providing a film that is excellent in transparency and color tone. If the temperature is lower than 100°C, the molecular chains will be constrained, and impurities may thus remain, resulting

in coloration and degradation in color tone. In addition, if the temperature exceeds 200°C, the mobility of the resin will be excessively increased, and the extracted impurities may be thus taken into the resin again, resulting in coloration and degradation in color tone. The solvent temperature for the washing according to the present invention is more preferably 125°C or higher and 175°C or lower.

In the present invention, the time of the washing treatment with the solvent is preferably 5 hours or longer. The treatment time for the washing is set to fall within the range mentioned above, thereby allowing the deterioration of the solvent to be suppressed, and allowing impurities to be efficiently removed. If the treatment time is shorter than 5 hours, impurities may fail to be completely extracted, thereby resulting in coloration and degradation in color tone. The upper limit of the treatment time is not particularly limited, but is 30 hours or shorter also from the viewpoint of productivity. The treatment time for the washing according to the present invention is more preferably 10 hours or longer, still more preferably 20 hours or longer.

Furthermore, in the present invention, the washing solvent preferably contains therein fine bubbles. The fine bubbles in the present invention are bubbles that are 100 um or less in diameter, and the method for providing the washing solvent containing fine bubbles therein is not particularly limited, but for example, the known device exemplified in Japanese Patent Laid-open Publication No. 2007-21343 A can be used. When the solvent contains therein fine bubbles, the wettability of the washing solvent to the polymer powder or the film is enhanced to make the washing solvent more likely to permeate the polymer powder or the film, and a washing effect can be thus efficiently obtained. Examples of the gas species contained in the fine bubbles include nitrogen ($N_2$), oxygen ($O_2$), and carbon dioxide ($CO_2$) , but any gas may be used. In particular, oxygen is preferred for promoting the adsorption by interaction with the functional group of the resin.

For the PAS film according to the present invention, the surface roughness (Ra) of at least one film surface thereof is preferably 10 nm or more and 200 nm or less. SRa is a parameter of three-dimensional surface roughness, which means average roughness in the center plane in the case of approximating a surface roughness curve with a sine curve, and is defined as center plane average roughness. The center plane average roughness is obtained by extending the center line average roughness (Ra) as a two-dimensional roughness parameter, described in JIS-B0601-1994, to three dimensions, and is obtained by dividing the volume of the part surrounded by the surface-profile curved surface and the center plane by the measured area. The center plane average roughness is defined by the following formula (ii), where the center plane is an XY plane, the longitudinal direction is a Z axis, and the measured surface-profile curve is f(x, y). In this regard, Lx is an X-direction measurement length, and Ly is a Y-direction measurement length.

[Mathematical formula 1]

$$(\mathrm{ii})\quad SRa = \frac{1}{S_M}\int_0^{Lx}\int_0^{Ly}|f(x,y)|dxdy \qquad S_M = Lx \times Ly$$

The SRa is set to fall within the range mentioned above, thereby providing a film that is excellent in running performance. If the surface roughness (Ra) of the film surface is less than 10 nm, the surface will be smooth, and the friction at the time of conveyance may be thus increased, thereby degrading the running performance. If the surface roughness (SRa) of the film surface exceeds 200 nm, light will be reflected due to irregularities of the surface, and the transparency may be thud degraded. The surface roughness (SRa) of the film surface is more preferably 10 nm or more and 100 nm or less, still more preferably 20 nm or more and 50 nm or less. In order to cause the surface roughness (SRa) of the film surface to fall within the range mentioned above, the surface roughness (SRa) can be controlled with the particles or other resin contained in the film described later, and controlled with the laminated configuration of the film described later. The surface roughness (SRa) of the film surface can be evaluated by an approach described later.

For the PAS film according to the present invention, the depth volume (Vv) from a reference surface on at least one film surface is preferably 50 $\mu m^3$ or more and 800 $\mu m^3$ or less. In the present invention, the depth volume (Vv) is measured by VertScan from Ryoka Systems Inc., based on a measurement method described later, and is the sum of the volumes of respective recesses from the reference surface in one visual field. In the present invention, the reference surface refers to a hand surface that has the same depth volume as the protrusion volume, which is a surface automatically set by VertScan analysis software. The reduced depth volume (Vv) indicates that the film surface is less recessed.

The depth volume (Vv) is set to fall within the range that is equal to or less than the above upper limit, thereby allowing a film with a film surface less recessed and with an excellent surface quality, whereas the depth volume (Vv) is set to be equal to or more than the above lower limit, thereby allowing the friction at the time of conveyance to be kept from excessively increasing, and allowing the running performance at the time of processing to be improved. The depth volume (Vv) is more preferably 100 $\mu m^3$ or more and 600 $\mu m^3$ or less, still more preferably 150 $\mu m^3$ or more and 400 $\mu m^3$ or less. In order to cause the depth volume (Vv) of the film surface to fall within the range mentioned above, the depth volume (Vv) can be achieved by an approach of control with the particles or other resin contained in the film described later, or an approach of control with the laminated configuration of the film described later. The depth volume

(Vv) of the film surface can be evaluated by an approach described later.

For the PAS film according to the present invention, the depth volume (Vv) (unit: $\mu m^3$) and the number of protrusions (n) (unit: number) from the reference surface on at least one film surface preferably satisfy the following formula (iii). In the present invention, the number of protrusions is the number of protrusions per visual field, measured by the VertScan and obtained with the threshold as a reference surface.

$$0.01 \leq Vv/n \leq 3.0 \text{ Formula (iii).}$$

Vv/n represents a depth volume for one protrusion, and for example, in a case where the film surface has a scratch, Vv/n tends to be increased in the case of a scratch with large unevenness, whereas Vv/n tends to be decreased in the case of a scratch with small unevenness. The Vv/n is set to be equal to or more than the above lower limit, thereby allowing the friction at the time of conveyance to be kept from excessively increasing, and allowing the running performance at the time of processing to be improved. In addition, the Vv/n is set to be equal to or less than the above upper limit, thereby allowing the surface quality to be improved. The Vv/n is more preferably 0.1 $\mu m^3$/number or more and 1.5 $\mu m^3$/number or less, still more preferably 0.1 $\mu m^3$/number or more and 0.5 $\mu m^3$/number or less. In order to cause the Vv/n to fall within the range mentioned above, the Vv/n can be controlled with the particles or other resin contained in the film described later, and controlled with the laminated configuration of the film described later. The Vv/n can be evaluated by an approach described later.

For the PAS film according to the present invention, the glossiness of at least one film surface is preferably 140% or more and less than 200%. The glossiness is set to fall within the range mentioned above, thereby leading to fewer surface irregularities that optically diffusely reflect light on the surface, with high surface smoothness, and when a metal layer is formed by vapor deposition, sputtering, plating, or the like of the metal layer for use as a circuit, a circuit can be obtained, which is less likely to cause surface irregularities and is excellent in transmission characteristics. In addition, when a metal layer is formed by vapor deposition or sputtering for use as a reflective film, the metal layer is less likely to cause surface irregularities. The glossiness is set to be equal to or less than the above upper limit, thereby allowing the transmission characteristics or the reflection efficiency to be kept from degrading due to the transfer of surface irregularities of the film by the metal layer with the surface irregularities excessively increased. In addition, the glossiness is set to be equal to or more than the above lower limit, thereby allowing the running performance at the time of processing to be kept from degrading due to the increased friction at the time of conveyance with the excessively smooth surface.

The PAS film according to the present invention contains particles and/or a dispersion, and the void formation ratio of the particles and/or dispersion is preferably 10% or less. In the present invention, the void formation ratio refers to the ratio of particles and a dispersion around which voids are formed to have a size of 10% or more of the cross-sectional area of the particles and dispersion in an FE-SEM image of a film cross section, and refers to a value measured by a method described later. The void formation ratio is set to fall within the range mentioned above, thereby allowing light diffusion and light reflection inside the film to be suppressed, then allowing the transparency of the film to be kept from being degraded, and allowing the color tone to be improved. The void formation ratio is more preferably 5.0% or less, still more preferably 3.0% or less. As a method for causing the void formation ratio to fall within the range mentioned above, the void formation ratio can be controlled with the particles or other resin contained in the film described later, and controlled with the laminated configuration of the film described later.

Examples of controlling the surface characteristics of the film described above include a method of providing the PAS film containing therein inert particles or a method of performing surface control with the film containing therein another thermoplastic resin (X) that is different from the PAS-based resin. In the case of containing inert particles, examples thereof can include inorganic particles such as silica, alumina, calcium carbonate, barium carbonate, barium titanate, barium sulfate, calcium silicate, magnesium oxide, titanium oxide, and zinc oxide. In the case of containing another thermoplastic resin, a polyarylate, a polyphenylene ether, a polyetherimide, a polysulfone, a polyphenylsulfone, and polyethersulfone can be used, but a polysulfone, a polyphenylsulfone, and a polyethersulfone are preferably used from the viewpoint of affinity for the PAS-based resin. In the present invention, from the viewpoint of achieving the transparency, the color tone, and running performance, a method of containing another thermoplastic resin is preferred.

The PAS film according to the present invention preferably has at least one absorption peak between 1145 $cm^{-1}$ and 1160 $cm^{-1}$ in an infrared absorption spectrum obtained by Fourier transform infrared spectroscopy (FT-IR). The absorption peak in the range mentioned above refers to a peak derived from the stretching vibration of the S=O bond, with the increased affinity between the PAS-based resin and the thermoplastic resin (X), and thus, a film can be obtained, with transparency achieved because of fine and uniform dispersion in the PAS-based resin, and with surface roughness allowed to be provided by the thermoplastic resin (X) and thus running performance combined. Having the absorption peak in the range mentioned above can be achieved by providing the thermoplastic resin (X) containing a resin having a sulfonate group, for example, a polysulfone, a polyphenylsulfone, or a polyethersulfone at a predetermined

concentration.

For the PAS film according to the present invention, the content $W_{II}$ of the thermoplastic resin (X) is preferably 0.01 parts by mass or more and 5.0 parts by mass or less, where the total of the content $W_I$ of the PAS-based resin and the content $W_{II}$ of the thermoplastic resin (X) that is different from the PAS-based resin is regarded as 100 parts by mass. For achieving a balance between the running performance and the transparency, the content $W_{II}$ of the thermoplastic resin (X) is more preferably 0.2 parts by mass or more and 1.0 parts by mass or less. The content of the thermoplastic resin (X) is set to be equal to or less than the above upper limit, thereby allowing the transparency to be kept from being degraded due to the refractive index difference of the resin. In addition, the content $W_{II}$ of the thermoplastic resin (X) is set to be equal to or more than the above lower limit, thereby allowing the quality to be kept from being degraded by the degraded running performance in the case of the film.

The PAS film according to the present invention preferably has two or more layers containing the PAS-based resin as a main component, where at least one outermost layer is a layer (layer A) containing the PAS-based resin as a main component and containing at least one thermoplastic resin (X) that is different from the PAS-based resin. The composition of the two or more layers allows the film to have multiple characteristics such as transparency, color tone, running performance, and surface quality in combination. Examples of the laminated configuration include multilayer configurations such as A/B, A/B/A, A/B/A/B, and A/B/A/B/A, where a layer containing the PAS-based resin as a main constituent is referred to as a layer B.

The PAS film according to the present invention preferably has three or more layers containing the PAS-based resin as a main component, where both outermost layers are each a layer (layer A) containing the PAS-based resin as a main component and containing at least one thermoplastic resin (X) that is different from the PAS-based resin, because the PAS film has multiple controllable characteristics in combination. Examples of the laminated configuration include multilayer configurations such as A/B/A and A/B/A/B/A. In the present invention, a three-layer configuration of A/B/A is more preferred from the viewpoint of transparency, color tone, surface quality, and running performance.

For the PAS film according to the present invention, the layer A preferably has at least one absorption peak between 1145 $cm^{-1}$ and 1160 $cm^{-1}$ in an infrared absorption spectrum obtained by Fourier transform infrared spectroscopy (FT-IR).

For the PAS film according to the present invention, preferably, in the layer A, another thermoplastic resin (X) that is different from the PAS-based resin is incompatible with the PAS-based resin, and another thermoplastic resin (X) that is different from the PAS-based resin is contained as a dispersion in the PAS-based resin. In the present invention, the fact that another thermoplastic resin (X) that is different from the PAS-based resin is incompatible with the PAS-based resin, and the fact that another thermoplastic resin (X) that is different from the PAS-based resin is contained as a dispersion in the PAS-based resin mean that the PAS-based resin and another thermoplastic resin (X) that is different from the PAS-based resin form a constituent sea-island structure, where the PAS-based resin constitutes a sea component, and the other thermoplastic resin (X) that is different from the PAS-based resin constitutes an island component. Having a dispersion that is incompatible with the PAS-based resin in the layer A containing the PAS-based resin as a main component allows surface irregularities to be formed and controlled, and allows a film that is excellent in transparency, running performance, and quality to be obtained. In addition, the shape of the dispersion is not to be considered particularly limited. The form of a cross section of the film can be confirmed by transmission electron microscope (TEM) observation, scanning electron microscope (SEM) observation, or the like, and examples of the form include a circular shape, an elliptical shape, a spindle shape, and an irregular shape.

For the PAS film according to the present invention, the dispersion preferably has an aspect ratio of 5.0 or more and 15.0 or less, determined by a measurement method described later. In the present invention, the aspect ratio refers to a value that is calculated from the ratio of the major axis to the minor axis in the dispersion diameter of the thermoplastic resin (X) present as a dispersed phase in the PAS-based resin. The aspect ratio in the range mentioned above indicates the strong interaction between the PAS-based resin and the thermoplastic resin (X). Thus, voids, which are a factor for degrading the transparency in the stretching step, are not formed, thereby allowing the transparency to be improved, which is preferred. The aspect ratio of the dispersion is set to be equal to or more than the above lower limit, thereby allowing the transparency to be kept from being degraded due to the formation of voids in the stretching step. In contrast, the aspect ratio of the dispersion is set to be equal to or less than the above upper limit, thereby eliminating the need to set any condition for extremely increasing the stretch ratio, and allowing the productivity to be kept from being degraded due to breakage during the film forming step. The lower limit of the aspect ratio is more preferably 7.0 or more. The upper limit of the aspect ratio is more preferably 12.0 or less, still more preferably 10.0 or less. The aspect ratio can be controlled with the stretch ratio among film forming conditions described later.

For the PAS film according to the present invention, the major axis of the dispersion is preferably 200 to 2000 nm. The major axis of the dispersion is set to fall within the range mentioned above, thereby allowing surface irregularities to be formed, and allowing the running performance and the surface quality to be improved, which is preferred. The major axis of the dispersion is set to be equal to or more than the above lower limit, thereby reducing the formation of surface irregularities, and smoothing the surface, and as a result, the friction at the time of conveyance can be kept from

increasing, and then degrading the running performance and the surface quality. In contrast, the major axis of the dispersion is set to be equal to or less than the above upper limit, thereby allowing the transparency to be kept from being degraded due to the diffusion of light by the dispersion. The major axis of the dispersion is more preferably 400 to 1000 nm. The major axis of the dispersion can be controlled with the stretch ratio among the film forming conditions described later. In the present invention, the major axis of the dispersion can be calculated by an approach described later.

For the PAS film according to the present invention, the thickness ratio of the layer A is preferably 0.1% or more and 10% or less with respect to the total thickness of the film. The thickness ratio of layer A is set to fall within the range mentioned above, thereby allowing the formation of dense surface irregularities to be facilitated, and the amount of the dispersion in the entire film to be reduced, and thus, the transparency, the color tone, the surface quality can be improved, which is preferred. The thickness ratio of the layer A is set to be equal to or more than the above lower limit, thereby reducing the formation of surface irregularities, and smoothing the surface, and as a result, the friction at the time of conveyance can be kept from increasing, and then degrading the running performance and the surface quality. In addition, the thickness ratio of the layer A is set to be equal to or lower than the above upper limit, thereby densely forming surface irregularities, and thus providing excellence in transparency. The thickness ratio of layer A is more preferably 0.5% or more and 5.0% or less, more preferably 1.0% or more and 3.0% or less. The thickness ratio of layer A can be controlled with the extruding condition among the film forming conditions. In the present invention, the thickness ratio of layer A can be calculated by an approach described later.

The thickness of the polyarylene sulfide film according to the present invention is not particularly limited, but is preferably 10 to 150 μm, more preferably 20 to 125 μm, still more preferably 25 to 100 um from the viewpoint of film fabrication processibility.

Regarding the method for producing the polyarylene sulfide film according to the present invention, a method for producing a film in the case of using a polyphenylene sulfide resin (hereinafter, sometimes abbreviated as a PPS resin) as a polyarylene sulfide-based resin will be described as an example, but the present invention is not limited to this example.

A sodium sulfide and a p-dichlorobenzene are blended, and reacted under high temperature and high pressure in an amide-based polar solvent such as an N-methyl-2-pyrrolidone (NMP). If necessary, it is also possible to contain therein a copolymerization component such as an m-dichlorobenzene or a trihalobenzene. With a potassium hydroxide, an alkali metal carboxylate, or the like added thereto as a polymerization degree modifier, a polymerization reaction is developed at 230 to 290°C. The polymer is cooled after the polymerization, and the polymer as a water slurry is filtered through a filter to obtain a moist granular polymer. The granular polymer with an amide-based polar solvent added thereto is subjected to a stirring treatment at a temperature of 30 to 100°C and then washed, washed several times with ion-exchanged water at 30 to 80°C, washed several times with ab aqueous solution of a metal salt such as a calcium acetate, and then dried to obtain a polymer powder of polyphenylene sulfide.

In the present invention, in the case of washing the polymer powder, the obtained polymer powder is subjected to a washing treatment at a temperature of 100 to 200°C for 6 to 24 hours in a solvent of NMP, and washed several times with pure water at 30 to 80°C to obtain a polymer powder (washed). This polymer powder is put into an extruder with a vent, melt-extruded into a strand shape, cooled with water at a temperature of 25°C, and then cut to prepare chips as PPS chips.

The polymer powder and/or polymer powder (washed) obtained above as a polyarylene sulfide-based resin and inorganic particles and/or another thermoplastic resin (X), and the like are mixed in arbitrary proportions to prepare a masterbatch. The method for preparing the masterbatch according to the present invention is preferably, for example, a method of forming a masterbatch with the use of an apparatus to with a shear stress applied thereto, such as a twin-screw extruder. In this case, in the kneading section, kneading is preferably performed so as to reach the resin temperature range of: the melting point of the PAS-based resin (I) + 5°C or more and 80°C or less, more preferably the melting point of the PAS-based resin (I) + 10°C or more and 80°C or less, still more preferably the melting point of the PAS-based resin (I) + 15°C or more and 70°C or less. In addition, the screw rotation speed preferably falls within the range of 100 rpm or more and 1500 rpm or less. The dispersion diameter of the dispersed phase can be controlled by setting the resin temperature and the screw rotation speed within the preferred ranges.

In the present invention, first, the PPS chips dried under reduced pressure at 180°C for 3 hours, if necessary, and the masterbatch are mixed in predetermined proportions, then fed to a full-flight single-screw extruder with the melting section set at 300 to 350°C, passed through a filter, subsequently discharged from a T-die spinneret, and brought into close contact with a cooling drum with a surface temperature of 20 to 70°C while applying an electrostatic charge, and then rapidly cooled and solidified to obtain an unstretched film substantially non-oriented. In the case of a laminated film that has two or more layers, the two types of chips mentioned above are fed to separate melt-extrusion devices and heated to be equal to or higher than the melting points of the respective resins. The respective molten raw materials melted by the heating are laminated at an arbitrary lamination ratio (for example, 0.3 : 24.4 : 0.3 or 0.3 : 24.7) for two layers of layer containing a PPS as a main component/layer containing the PPS as a main component and containing at least one thermoplastic resin that is different from the PPS, or three layers of layer containing a PPS as a main

component and containing at least one thermoplastic resin that is different from the PPS/ layer containing the PPS as a main component/layer containing the PPS as a main component and containing at least one thermoplastic resin that is different from the PPS in a merging device provided between the melt-extrusion devices and a spinneret outlet, and extruded from the spinneret outlet on the slit. The sheet-shaped product is brought into close contact with a cooling drum with a surface temperature of 20 to 70°C such that the PPS layer is located on the cooling drum side, and then cooled and solidified to obtain a two-layer laminated sheet or three-layer laminated sheet substantially non-oriented.

Next, in the case of biaxially stretching the sheet, the unstretched film obtained as mentioned above is biaxially stretched with a sequential biaxial stretching machine or a simultaneous biaxial stretching machine in the range of equal to or higher than the glass transition point (Tg) of the polyarylene sulfide-based resin and equal to or lower than the cold crystallization temperature (Tcc), and then subjected to a single-stage or multistage heat treatment at a temperature in the range of 150 to 280°C to obtain a biaxially oriented film. As the stretching method, a sequential biaxial stretching method (a stretching method of combining the stretching in each direction, such as a method of stretching in the longitudinal direction and then in the width direction), a simultaneous biaxial stretching method (a method of stretching simultaneously in the longitudinal direction and the width direction), or a combined method thereof can be used. A sequential biaxial stretching method of stretching in the longitudinal direction and then in the width direction will be exemplified herein.

The unstretched film is heated by a group of heating rolls, and stretched to 2.0 to 4.5 times, more preferably 2.8 to 4.2 times in the longitudinal direction (MD direction), in a single stage or multiple stages of two or more stage (MD stretching). The stretching temperature falls within the range of Tg to Tcc, preferably (Tg + 5) to (Tcc - 10) °C. Thereafter, the stretched film is cooled by a group of cooling rolls at 20 to 50°C.

As a stretching method in the width direction (TD direction) following the MD stretching, for example, a method with a tenter used is common. With both ends of the film held by clips, the film is guided to the tenter for stretching in the width direction (TD stretching). The stretching temperature is preferably Tg to Tcc, more preferably within the range of preferably (Tg + 5) to (Tcc - 10) °C. The stretch ratio is preferably 3.0 to 5.0 times, preferably 3.0 to 4.5 times from the viewpoint of film flatness.

Next, an operation for heat fixation of the stretched film under tension (heat fixation treatment) is carried out. The heat fixation treatment is carried out in a single stage or multiple stages at a temperature in the range of 150 to 280°C, and the film is cooled down to room temperature, while being subjected to a relaxation treatment in the longitudinal and width directions, if necessary, and then wound up to obtain a biaxially oriented polyarylene sulfide film.

In the present invention, in the case of subjecting the film to a washing treatment, the obtained polyarylene sulfide film is subjected to a washing treatment at a temperature of 100 to 200°C for 5 to 30 hours in a solvent of NMP, and washed 3 to 5 times with pure water at 30 to 80°C to obtain the polyarylene sulfide film according to the present invention.

The polyarylene sulfide film according to the present invention is also excellent in the running performance and quality of the film surface while being excellent in transparency and color tone, and can be thus suitably used as a member for automobiles, a member for batteries, and an electric/electronic material, in particular, as various parts and industrial packaging materials that require transparency, for example, a protective material for a lower plate of a flexible printed board, and a capacitor material that requires the surface quality.

In addition, the polyarylene sulfide film according to the present invention may have various coating agents applied to both surfaces or one surface of the film in an in-line or off-line manner, for the purpose of improving the weather resistance and the adhesiveness, protecting the surface, and the like.

On the polyarylene sulfide film thus obtained, a conductive film is formed to produce a circuit board. In the case of using the conductive film as a transparent circuit, the conductive film is preferably a transparent or translucent conductor, and examples thereof include a film prepared by laminating one or more of a metal film such as an Ag film, a metal oxide film such as an ITO (indium tin oxide) film, and a resin film including conductive fine particles. Examples of the method for forming the conductor include, but are not particularly limited to, well-known methods such as sputtering and paste printing. Examples of patterning for the circuit board include well-known methods such as etching by photolithography and screen printing. Furthermore, if necessary, a through-hole is formed in the circuit board by a method such as drilling, laser, melting penetration to obtain a circuit board.

A circuit substrate obtained with the use of the polyarylene sulfide film according to the present invention is useful as a transparent antenna substrate, because of excellence in transparency and color tone.

[Method for Measurement of Characteristics]

(1) Light transmittance at wavelengths of 550 nm, 400 nm, and 600 nm

The measurements were made with the use of the following apparatus, and the light transmittance at each of the wavelengths was determined from the following formula.

Apparatus: UV measuring instrument U-3410
(manufactured by Hitachi Keisoku Co., Ltd.)
Wavelength range: 300 nm to 800 nm
Measurement speed: 120 nm/min
Measurement mode: Transmission

$$\text{Light transmittance (\%)} = (Tr1/Tr0) \times 100$$

where Tr1 is the intensity of light passing through the sample, and Tr0 is the intensity of light passing through the air at the same distance without passing through the sample.

(2) Yellowness (b value)

Tristimulus values X, Y, and Z were measured by a transmission method in accordance with JIS-Z-8722 (2000) with the use of a spectrophotometer CM-3600d (manufactured by KONICA MINOLTA, INC.). From the values, the lightness (L value) was calculated, and the yellowness (b value) in the Hunter Lab color system was calculated by the following formula.

$$\text{b value} = 7.0 \times (Y - 0.847 \times Z)/Y1/2.$$

(3) Surface roughness (SRa)

The average centerline roughness (SRa) was measured with the use of Surfcorder ET30HK manufactured by Kosaka Laboratory Ltd. under the following conditions.

Stylus tip radius of curvature: 2 um
Cut-off: 0.25 mm
Measurement length: 0.5 mm
Measurement interval: 5 um
Number of measurements: 40 times.

(4) Depth volume (Vv), number of protrusions (n)

The measurement was performed with the use of VertScan 2.0 R5300 GL-Lite-AC from Ryoka System Inc., and the imaging screen was subjected to a surface correction by polynomial quartic approximation with the attached analysis software to determine the depth volume (Vv) and the number of protrusions (n) with the threshold of 0 nm. The measurement conditions were as follows. The measurement was performed for both surfaces of the film, each with n = 100, and the average values thereof were regarded as the depth volume (Vv) and number of protrusions (n) for each surface. For Examples 26 and 52, the surface of the layer A was subjected to the measurement with n = 100, and the average values thereof were regarded as the depth volume (Vv) and number of protrusions (n) for each surface.

Manufacturer: Ryoka Systems Inc.
Device name: VertScan 2.0 R5300GL-Lite-AC
Measurement conditions: CCD camera SONY HR-57 1/2 inch
Objective lens: 5 x
Intermediate lens: 0.5 x
Wavelength filter: 530 nm white
Measurement mode: Wave
Measurement software: VS-Measure Version 5.5.1
Analysis software: VS-Viewer Version 5.5.1
Measurement area: 0.561 mm × 0.561 mm.

(5) Glossiness

With the use of a digital variable angle gloss meter UGV-5D manufactured by Suga Test Instruments Co., Ltd. in accordance with JIS K-7105 (1981), the film surface was subjected to measurement under conditions of: an incident

angle of 60°; and a light receiving angle of 60°, and the average of data at 5 points was regarded as the glossiness (%). The measurement was performed for both surfaces of the film, and the value of the surface with higher glossiness obtained is shown in the tables.

(6) Fourier transform infrared spectroscopy (FT-IR)

With the use of Frontier FT-IR manufactured by PerkinElmer Inc., a UATR IR unit is used to measure the spectral intensity by an attenuated total reflection method (ATR method) with diamond/ZnSe as a medium crystal. The measurement is made with the resolution of the spectroscope set to be 1 $cm^{-1}$, and the number of integrations of the spectrum set to be 16. The spectral intensity is regarded as the absorbance (arb. unit) at each wavelength. In the case of measuring a spectrum at the surface layer of the film, the surface layer of the film is brought into close contact with the medium crystal, and the measurement is performed. The close contact between the medium crystal and the sample is performed by applying a pressure with the use of a jig attached to the apparatus. The pressure is increased while observing the spectrum at the sample, and the measurement is performed at a time when the spectrum shape is not changed by the pressure. The spectral intensity is determined as the absorbance (arb. unit) at each wavelength.

In the present invention, in the case of a monolayer film, the measurement is performed by the above-mentioned approach from either one of the surfaces, and the presence or absence of any absorption peak between 1145 $cm^{-1}$ and 1160 $cm^{-1}$ is determined from the obtained infrared absorption spectrum. In the case of a laminated film, the measurement is performed by the above-mentioned approach from the surface formed of the layer A on the outermost layer side, and the presence or absence of any absorption peak is determined. If the laminated configuration is unknown, the measurement is performed by the above-mentioned approach from the both surfaces, and the presence or absence of any absorption peak is determined.

(7) Scanning electron microscope SEM observation at cut surface

The film was embedded in an epoxy resin, and then cut with a microtome in a direction parallel to the film longitudinal direction and perpendicular to the film surface without crushing the film cross section in the thickness direction. Next, the cross section of the cut film was, under a condition that no material alteration by heat, fixed on a sample stage of a scanning electron microscope, and subjected to a cross-sectional ion milling treatment with the use of an ion milling apparatus IM4000 PLUS manufactured by Hitachi High-Technologies Corporation, followed by Pt deposition. Then, the obtained film cross section was observed under the conditions of: an acceleration voltage of 3.0 kV and a working distance of 8.0 mm with the use of an field emission scanning electron microscope JSM-6700F manufactured by JEOL Ltd. to obtain an image.

(7-1) Void formation ratio of particles and dispersion

For the calculation of the void formation ratio of the particles and dispersion, the cross section was observed under the condition at an observation magnification of 30,000 times, and the obtained image was analyzed. It is to be noted that the observation site is considered randomly determined at the position where the particles and the dispersion are observed in the film cross section, and was determined such that the vertical direction of the image and the horizontal direction of the image were parallel respectively to the thickness direction of the film and the film plane direction.

For the observation image obtained, the area (D1) of each particle, the area (D1') of the dispersion, the area (D2) of voids around the particle, and the area (D2') of voids around the dispersion were calculated with the use of image analysis software (MacView ver 4.0 manufactured by Mountech Co., Ltd.). The case where the area D2 was 10% or more of the area D1 was determined to correspond to particles with voids formed, and the case where the area D2' was 10% or more of the area D1' was determined to correspond to a dispersion with voids formed. For the evaluation, the measurement was performed at 100 points for each of the particles and dispersion, and the void formation ratio was calculated from the numbers of particles and dispersions with voids formed.

Void formation ratio = (number of void-formation particles + number of void-formation dispersions)/number of measurement points (200 points) × 100.

(7-2) Major axis and aspect ratio of dispersion

For the major axis and aspect ratio of the dispersion, the cross section was observed under the condition at an observation magnification of 30,000 times, and the obtained image was analyzed. The obtained observation image was scanned as an image in an image analyzer (Leica Application Suite LAS ver 4.6 manufactured by Leica Microsystems GmbH), arbitrary twenty dispersions were selected, the circumscribed circle of each dispersed phase was determined, and the average value of the diameters of the circumscribed circles was regarded as the size of the dispersion. In addition, the major axis and minor axis of the dispersed phase were read, and the aspect ratio was calculated.

(7-3) Lamination thickness of layer A and lamination ratio of layer A

The lamination thickness of the layer A and the lamination ratio of the layer A were observed under the condition at an observation magnification of 5000 times, from the analysis of the obtained image, arbitrary five points were measured for the thickness of the layer A of the film, and the average value thereof was regarded as the layer thickness of the layer A.

In addition, the thickness of the entire film is observed under the condition at an observation magnification of 3000 times, and an image is taken such that the entire film in the thickness direction thereof can be observed. The thickness of the entire film was measured from the image obtained by the observation. If the entire film in the thickness direction thereof fails to be checked at the magnification mentioned above, several images are taken in the thickness direction, and the entire image is checked by joining the images. As samples for use in the thickness measurement, five points in total were selected at arbitrary positions, and the average of the measured values of the five samples was regarded as the film thickness of the sample.

(8) Transparency

White dots with diameters decremented by 10 um in order from 200 um to 10 um are printed on black drawing paper. Each film was overlaid on the black drawing paper, and whether the white points with the diameters were visible or not was determined above the film in accordance with the following criteria. C was determined to be defective in transparency.

AA: Visible down to 10 um (excellent transparency)
A: Visible down to 50 um (good transparency)
B: Visible down to 100 um (normal transparency)
C: Invisible even with 100 um (inferior transparency).

(9) Color tone

On white drawing paper, a color sample with a color model RGB varied is created with points that have a size of 0.5 mm in diameter. Points with B incremented by 10 from R (red) 255, G (green) 255, and B (blue) 0 to R 255, G 255, and B 250 are printed as a color sample. Each film was overlaid on the white drawing paper, and whether the color points were visible or not was determined at a position of 100 cm above the film in accordance with the following criteria. D was determined to be defective in color tone.

AA: Visible at R 255, G 255, and B 240 or more (excellent color tone)
A: Visible up to R 255, G 255, and B 230 (good color tone)
B: Visible up to R 255, G 255, and B 200 (inferior color tone)
C: Visible up to R 255, G 255, and B 180 (poor color tone)
D: visible up to R 255, G 255, and B 170 (significantly poor color tone).

(10) Running performance

With the use of a friction measuring instrument manufactured by Toyo Tester Kogyo, Ltd., the initial rise resistance value in a case where one surface of the film and the back surface thereof were overlapped in contact with each other and rubbed against each other in the MD direction was measured in accordance with ASTM-D 1894 (1999), and the maximum value was regarded as a static friction coefficient us. The case where the large initial rise exceeded the upper limit (5.0) of the measurement, however, was determined to be unmeasurable. Five sets (ten sheets) of samples were cut out, which were each a rectangle of 80 mm in width and 200 mm in length. The measurement was performed 5 times, and the average value was determined. From the static friction coefficient determined, the running performance was determined in accordance with the following criteria. D was determined to be defective in running performance.

A: μs = 0.50 or less (good running performance)
B: us = more than 0.50 and 0.60 or less (normal running performance)
C: us = more than 0.60 and 0.70 or less (slightly inferior running performance)
D: us = more than 0.70 (poor running performance).

(11) Surface quality

Light of an LED light source was applied to 1 $m^2$ of the film to count scratches on the surface, which were visible with the transmitted light, and the surface quality was determined from the number of scratches per 1 $m^2$ in accordance with the following criteria.

AA: less than 50 /$m^2$
A: 50 /$m^2$ or more and less than 100 /$m^2$
B: 100 /$m^2$ or more and less than 150 /$m^2$
C: 150 /$m^2$ or more and less than 200 /$m^2$
D: 200 /$m^2$ or more

[Examples]

(Reference Example 1) Method for producing PPS resin (granule)

To a 1 liter autoclave with a process stirrer, 1.00 mol of 47% sodium hydrosulfide, 1.03 mol of 96% sodium hydroxide, 1.65 mol of N-methyl-2-pyrrolidone (NMP), 0.45 mol of sodium acetate, and 150 g of ion-exchanged water were charged, and gradually heated to 225°C over about 3 hours while stirring at 240 rpm and passing nitrogen at normal pressure, and after distilling off 211 g of water and 4 g of NMP, the reaction vessel was then cooled to 160°C.

Next, 1.00 mol of p-dichlorobenzene (p-DCB) and 1.31 mol of NMP were added thereto. The reaction vessel was subsequently sealed under a nitrogen gas. While stirring at 240 rpm, the temperature was raised from 200°C to 235°C at a rate of 0.6 °C/min, and after reaching 235°C, the reaction was continued at 235°C for 95 minutes. Thereafter, the temperature was raised to 270°C at a rate of 0.8°C/min, and held for 100 minutes. After reaching 270°C, 1 mol of water was injected into the system over 15 minutes. After a lapse of 100 minutes at 270°C, the system was cooled to 200°C at a rate of 1.0 °C/min, and then rapidly cooled to near room temperature. The contents were taken out, and diluted with 0.4 liters of NMP, then stirred at 85°C for 30 minutes, and the solvent and the solid were then filtered off through a sieve (80 mesh). Following the post-treatment step, 0.5 liters of NMP was added to the obtained solid, and the mixture was stirred at 85°C for 30 minutes and filtered off. The obtained solid was washed three times with 0.9 liters of warm water and filtered off. Furthermore, 1 liter of warm water was added to the obtained particles, and the mixture was washed two times and filtered off to obtain polymer particles. These particles were subjected to hot-air drying at 80°C, and then dried under reduced pressure at 120°C to obtain granules (PPS granules) of a polyphenylene sulfide (PPS) resin with a melting point of 280°C and a mass average molecular weight of 70,000.

(Reference Example 2) Method for producing PPS pellet

The PPS resin (granules) prepared in Reference Example 1 was put into a vented co-rotating twin-screw kneading extruder heated to 320°C, melt-extruded to be discharged into a strand, cooled with water at a temperature of 25°C, and then immediately cut to prepare a PPS pellet 1.

(Reference Example 3) Preparation of master pellet (MB1) of PPS granules and thermoplastic resin

A vented twin-screw kneading extruder of a co-rotating type provided with one kneading-paddle kneading section was heated to 320°C, and from the feed port, the PPS granules obtained in Reference Example 1 and a polyethersulfone (PESU: Solvay Advanced Polymers, L.L.C, Veradel 3600) were fed respectively to reach 90 parts by mass and 10 parts by mass, melt-kneaded at a screw rotation speed of 200 rpm, then discharged into a strand, cooled with water at a temperature of 25°C, and then immediately cut to prepare a master pellet (MB1) containing 10 parts by mass of the PESU.

(Reference Example 4) Preparation of master pellet (MB2) of PPS granules and particles

A particle masterbatch (MB2) with a particle content of 10% by mass was prepared in the same manner as in Reference Example 3 except for melt-kneading a mixture of 90% by mass of the PPS resin (granules) prepared in

Reference Example 1 and 10% by mass of a calcium carbonate (average particle diameter: 1.0 μm) as inert particles.

(Reference Example 5) Preparation of master pellet (MB3) of PPS granules and thermoplastic resin

A vented twin-screw kneading extruder of a co-rotating type provided with one kneading-paddle kneading section was heated to 320°C, and from the feed port, the PPS granules obtained in Reference Example 1 and a polyphenylsulfone (PPSU: Solvay Advanced Polymers, L.L.C, Radel R5600-NT) were fed respectively to reach 90 parts by mass and 10 parts by mass, melt-kneaded at a screw rotation speed of 200 rpm, then discharged into a strand, cooled with water at a temperature of 25°C, and then immediately cut to prepare a master pellet (MB3) containing 10 parts by mass of the PPSU.

(Examples 1 to 12)

The PPS resin (granules) prepared in Reference Example 1 was subjected to a washing treatment under the conditions shown in Table 1-1 with the use of an NMP as a solvent under the conditions shown in Table 1-1, and washed three times with pure water at a temperature of 40°C to obtain PPS granules (washed). These PPS granules (washed) were put into a vented co-rotating twin-screw kneading extruder heated to 320°C, melt-extruded to be discharged into a strand, cooled with water at a temperature of 25°C, and then immediately cut to prepare a PPS pellet (washed).

The PPS pellet (washed) and the PPS master pellet were mixed so as to be homogeneous at the ratio shown in Table 1, dried under reduced pressure at 180°C for 3 hours, and then fed to a single-screw extruder with a melting section heated to 315°C.

Then, the molten polymer was passed through a fiber-sintered stainless metal filter (20 um cut), melt-extruded from a spinneret of a T die set to a temperature of 310°C, and then closely attached, cooled, and solidified while applying an electrostatic charge to a cast drum with a surface temperature of 25°C to obtain an unstretched film of 350 um in thickness. Then, the obtained unstretched film was stretched at a ratio of 3.5 times in the longitudinal direction of the film at a stretching temperature of 105°C with the use of a longitudinal stretching machine including multiple groups of rolls heated and through the use of the difference between the circumferential speeds of the rolls. Thereafter, with both ends of the film held by clips, the film was guided to a tenter, and stretched at a ratio of 3.5 times in the width direction of the film at a stretching temperature of 100°C. Subsequently, the film was subjected to a heat treatment at 280°C, then subjected to a 2% relaxation treatment, and cooled to room temperature, and the film edge was then removed to obtain a polyarylene sulfide film of 25 um in thickness. The physical properties and characteristics of the obtained film are shown in Table 1-1.

(Example 13)

A polyarylene sulfide film was obtained in the same manner as in Example 1, except that the PPS resin (granules) was not subjected to any washing treatment.

(Example 14)

A polyarylene sulfide film was obtained in the same manner as in Example 1, except that the PPS resin (granules) was not subjected to any washing treatment and supplied as only the PPS pellet 1.

(Comparative Example 1)

A polyarylene sulfide film was obtained in the same manner as in Example 1, except that the PPS pellet 1 and the masterbatch were mixed so as to have the composition and ratio shown in Table 1-1, and that the washing treatment was performed under the conditions shown in Table 1-1.

(Comparative Example 2)

A polyarylene sulfide film was obtained in the same manner as in Example 1, except that the PPS resin (granules) was not subjected to any washing treatment, only as the PPS pellet 1, and that the PPS pellet 1 and the masterbatch were mixed so as to have the composition and the ratio in Table 1-1.

(Examples 15 to 25)

The PPS resin (granules) prepared in Reference Example 1 was subjected to a washing treatment under the

conditions shown in Table 1-2 with the use of an NMP as a solvent under the conditions shown in Table 1-2, and washed three times with pure water at a temperature of 40°C to obtain PPS granules (washed). These PPS granules (washed) were put into a vented co-rotating twin-screw kneading extruder heated to 320°C, melt-extruded to be discharged into a strand, cooled with water at a temperature of 25°C, and then immediately cut to prepare a PPS pellet (washed).

Raw materials for the layer A and the layer B were prepared so as to provide the PPS pellet (washed) and the PPS master pellet with the composition and ratio shown in Table 1-2, and the respective raw materials were separately vacuum-dried at 180°C for 3 hours, then separately fed to two single-screw extruders heated to 315°C, guided in molten states so as to provide three layers (laminated configuration A/B/A) with the lamination ratio in Table 1-2 in a laminating device located above the spinnerets, subsequently discharged from a T-die spinneret, and closely attached, quenched, and solidified while applying an electrostatic charge to a cast drum with a surface temperature of 25°C to obtain an unstretched film of 350 um in thickness. Then, the obtained unstretched film was stretched at a ratio of 3.5 times in the longitudinal direction of the film at a stretching temperature of 105°C with the use of a longitudinal stretching machine including multiple groups of rolls heated and through the use of the difference between the circumferential speeds of the rolls. Thereafter, with both ends of the film held by clips, the film was guided to a tenter, and stretched at a ratio of 3.5 times in the width direction of the film at a stretching temperature of 100°C. Subsequently, the film was subjected to a heat treatment at 280°C, then subjected to a 2% relaxation treatment, and cooled to room temperature, and the film edge was then removed to obtain a polyarylene sulfide film of 25 um in thickness. The physical properties and characteristics of the obtained film are shown in Table 1-1.

(Example 26)

A polyarylene sulfide film was obtained in the same manner as in Example 16, except for changing the laminated configuration in the laminating device to two layers of A/B, and using the lamination ratio shown in Table 1-2.

(Example 27)

A polyarylene sulfide film was obtained in the same manner as in Example 16, except that the PPS resin (granules) was not subjected to any washing treatment for use as the PPS pellet 1.

(Comparative Example 3)

A polyarylene sulfide film was obtained in the same manner as in Example 15, except that raw materials were fed so as to have the composition and ratio shown in Table 1-2.

(Examples 28 to 39)

The PPS pellet 1 and the PPS master pellet were mixed so as to be homogeneous at the ratio shown in Table 2-1, dried under reduced pressure at 180°C for 3 hours, and then fed to a single-screw extruder with a melting section heated to 315°C. Then, the molten polymer was passed through a fiber-sintered stainless metal filter (20 um cut), melt-extruded from a spinneret of a T die set to a temperature of 310°C, and then closely attached, cooled, and solidified while applying an electrostatic charge to a cast drum with a surface temperature of 25°C to obtain an unstretched film of 350 um in thickness. Then, the obtained unstretched film was stretched at a ratio of 3.5 times in the longitudinal direction of the film at a stretching temperature of 105°C with the use of a longitudinal stretching machine including multiple groups of rolls heated and through the use of the difference between the circumferential speeds of the rolls. Thereafter, with both ends of the film held by clips, the film was guided to a tenter, and stretched at a ratio of 3.5 times in the width direction of the film at a stretching temperature of 100°C. Subsequently, the film was subjected to a heat treatment at 280°C, then subjected to a 2% relaxation treatment, and cooled to room temperature, and the film edge was then removed to obtain a polyarylene sulfide film of 25 um in thickness.

The obtained film was subjected to a washing treatment under the conditions shown in Table 2-1 with the use of an NMP as a washing solvent, and washed five times with pure water at a temperature of 40°C to obtain a washed polyarylene sulfide film. The physical properties and characteristics of the obtained film are shown in Table 2-1.

(Comparative Example 4)

A polyarylene sulfide film was obtained in the same manner as in Example 28, except that the PPS pellet 1 and the masterbatch were mixed so as to have the composition and ratio shown in Table 2-1, and that the washing treatment was performed under the conditions shown in Table 2-1.

(Examples 40 to 50)

Raw materials for the layer A and the layer B were prepared so as to provide the PPS pellet 1 and the PPS master pellet with the composition and ratio shown in Table 2-2, and the respective raw materials were separately vacuum-dried at 180°C for 3 hours, then separately fed to two single-screw extruders heated to 315°C, guided in molten states so as to provide three layers (laminated configuration A/B/A) with the lamination ratio in Table 2-2 in a laminating device located above the spinnerets, subsequently discharged from a T-die spinneret, and closely attached, quenched, and solidified while applying an electrostatic charge to a cast drum with a surface temperature of 25°C to obtain an unstretched film of 350 um in thickness. Then, the obtained unstretched film was stretched at a ratio of 3.5 times in the longitudinal direction of the film at a stretching temperature of 105°C with the use of a longitudinal stretching machine including multiple groups of rolls heated and through the use of the difference between the circumferential speeds of the rolls. Thereafter, with both ends of the film held by clips, the film was guided to a tenter, and stretched at a ratio of 3.5 times in the width direction of the film at a stretching temperature of 100°C. Subsequently, the film was subjected to a heat treatment at 280°C, then subjected to a 2% relaxation treatment, and cooled to room temperature, and the film edge was then removed to obtain a polyarylene sulfide film of 25 um in thickness.

The obtained film was subjected to a washing treatment under the conditions shown in Table 2-2 with the use of an NMP as a washing solvent, and washed five times with pure water at a temperature of 40°C to obtain a washed polyarylene sulfide film. The physical properties and characteristics of the obtained film are shown in Table 2-2.

(Example 51)

A polyarylene sulfide film was obtained in the same manner as in Example 41, except for changing the laminated configuration in the laminating device to two layers of A/B, and using the lamination ratio shown in Table 2-2.

(Comparative Example 5)

A polyarylene sulfide film was obtained in the same manner as in Example 41, except that raw materials were fed so as to have the composition and ratio shown in Table 2-2.

[Table 1-1]

| | | | | | Example 1 | Example 2 | Example 3 | Example 4 | Example 5 | Example 6 | Example 7 | Example 8 | Example 9 | Example 10 | Example 11 | Example 12 | Example 13 | Example 14 | Comparative Example 1 | Comparative Example 2 |
|---|---|---|---|---|---|---|---|---|---|---|---|---|---|---|---|---|---|---|---|---|
| Raw material | Layer A composition | Resin | Type | - | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet 1 | PPS pellet 1 | PPS pellet (Washing) | PPS pellet 1 |
| | | | Amount | Parts by mass | 99 | 99 | 99 | 99 | 99 | 99 | 99 | 99 | 99.9 | 96 | 99 | 99 | 99 | 100 | 93 | 93 |
| | | Masterbatch | Type | - | MB1 | MB1 | MB1 | MB1 | MB1 | MB1 | MB1 | MB1 | MB1 | MB1 | MB2 | MB3 | MB1 | - | MB2 | MB2 |
| | | | Amount | Parts by mass | 1 | 1 | 1 | 1 | 1 | 1 | 1 | 1 | 0.1 | 4 | 1 | 1 | 1 | - | 7 | 7 |
| | Layer B composition | Resin | Type | - | - | - | - | - | - | - | - | - | - | - | - | - | - | - | - | - |
| | | | Amount | Parts by mass | - | - | - | - | - | - | - | - | - | - | - | - | - | - | - | - |
| Washing treatment | Solvent | | | - | NMP | NMP | NMP | NMP | NMP | NMP | NMP | NMP | NMP | NMP | NMP | NMP | - | - | NMP | - |
| | Temperature | | | °C | 150 | 150 | 150 | 150 | 120 | 180 | 150 | 150 | 150 | 150 | 150 | 150 | - | - | 150 | - |
| | Time | | | h | 24 | 24 | 12 | 6 | 24 | 24 | 24 | 24 | 24 | 24 | 24 | 24 | - | - | 24 | - |
| | Fine bubble | | | - | $O_2$ | - | - | - | - | - | $CO_2$ | $N_2$ | - | - | - | - | - | - | - | - |
| Film configuration | Laminated configuration | | | | Only layer A | Only layer A | Only layer A | Only layer A | Only layer A | Only layer A | Only layer A | Only layer A | Only layer A | Only layer A | Only layer A | Only layer A | Only layer A | Only layer A | Only layer A | Only layer A |
| | Thickness of layer A in film | | | μm | 25 | 25 | 25 | 25 | 25 | 25 | 25 | 25 | 25 | 25 | 25 | 25 | 25 | 25 | 25 | 25 |
| | Thickness ratio of layer A | | | % | 100 | 100 | 100 | 100 | 100 | 100 | 100 | 100 | 100 | 100 | 100 | 100 | 100 | 100 | 100 | 100 |
| | Major axis of dispersion in layer A | | | nm | 700 | 700 | 700 | 700 | 700 | 700 | 700 | 700 | 700 | 700 | - | 1400 | 700 | - | - | - |
| | Aspect ratio of dispersion in layer A | | | - | 7.2 | 7.2 | 7.2 | 7.2 | 7.2 | 7.2 | 7.2 | 7.2 | 7.2 | 7.2 | - | 10.5 | 7.2 | - | - | - |
| | Void formation ratio | | | % | 1 | 1 | 1 | 1 | 1 | 1 | 1 | 1 | 1 | 1 | 80 | 1 | 1 | - | 80 | 80 |
| Spectral light transmittance | Wavelength 550 nm (Ta) | | | % | 83.0 | 81.3 | 81.0 | 79.5 | 79.2 | 80.9 | 81.3 | 81.3 | 81.5 | 78.5 | 76.1 | 79.6 | 77.5 | 81.8 | 73.8 | 73.0 |
| | Wavelength 400 nm (Tb) | | | % | 76.1 | 74.0 | 73.3 | 72.2 | 70.9 | 73.1 | 74.3 | 74.2 | 74.0 | 71.3 | 68.4 | 73.6 | 69.8 | 73.8 | 65.0 | 64.8 |
| | Wavelength 600 nm (Tc) | | | % | 83.9 | 82.4 | 82.1 | 80.9 | 80.5 | 82.0 | 82.5 | 82.3 | 82.6 | 80.0 | 77.2 | 82.0 | 80.0 | 82.9 | 76.2 | 76.5 |
| Light transmittance difference Tc - Tb | | | | % | 7.8 | 8.4 | 8.8 | 8.7 | 9.6 | 8.9 | 8.2 | 8.1 | 8.6 | 8.7 | 8.8 | 8.4 | 10.2 | 9.1 | 11.2 | 11.7 |
| Color tone | b value | | | - | 1.8 | 2.2 | 2.6 | 2.8 | 2.8 | 2.7 | 2.1 | 2.2 | 2.2 | 2.6 | 2.9 | 2.5 | 3.5 | 3.5 | 5.0 | 5.8 |
| | L value | | | - | 92.0 | 91.8 | 91.6 | 91.5 | 91.5 | 91.5 | 91.7 | 91.7 | 92.3 | 90.8 | 90.5 | 92.5 | 91.5 | 91.9 | 88.3 | 87.5 |
| Surface roughness (Ra) | | | | nm | 25 | 25 | 25 | 25 | 25 | 25 | 25 | 25 | 17 | 40 | 40 | 35 | 25 | 8 | 75 | 75 |
| Presence or absence of FT-IR peak | | | | - | Presence | Presence | Presence | Presence | Presence | Presence | Presence | Presence | Presence | Presence | Absence | Presence | Presence | Absence | Absence | Absence |
| Depth volume (Vv) | | | | $\mu m^3$ | 540 | 540 | 540 | 540 | 540 | 540 | 540 | 540 | 750 | 340 | 380 | 650 | 540 | 1200 | 320 | 320 |
| Depth volume (Vv)/number of protrusions (n) | | | | $\mu m^3$/number | 1.2 | 1.2 | 1.2 | 1.2 | 1.2 | 1.2 | 1.2 | 1.2 | 2.8 | 0.8 | 0.7 | 1.5 | 1.2 | 5.2 | 0.7 | 0.7 |
| Glossiness | | | | % | 175 | 175 | 175 | 175 | 175 | 175 | 175 | 175 | 175 | 170 | 130 | 170 | 175 | 180 | 130 | 130 |
| Transparency | | | | - | AA | AA | AA | A | A | AA | AA | AA | AA | A | B | A | B | AA | C | C |
| Color tone | | | | - | AA | A | B | B | B | B | AA | AA | A | B | B | A | C | C | C | D |
| Running performance | | | | - | A | A | A | A | A | A | A | A | B | A | A | A | A | C | A | A |
| Surface quality | | | | - | B | B | B | B | B | B | B | B | C | A | A | B | B | D | A | A |

[Table 1-2]

| | | | | | Example 15 | Example 16 | Example 17 | Example 18 | Example 19 | Example 20 | Example 21 | Example 22 | Example 23 | Example 24 | Example 25 | Example 26 | Example 27 | Comparative Example 3 |
|---|---|---|---|---|---|---|---|---|---|---|---|---|---|---|---|---|---|---|
| Raw material | Layer A composition | Resin | Type | - | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet 1 | - |
| | | | Amount | Parts by mass | 99 | 97 | 95 | 80 | 50 | 99.9 | 97 | 97 | 99 | 97 | 97 | 97 | 97 | - |
| | | Masterbatch | Type | - | MB1 | MB1 | MB1 | MB1 | MB1 | MB1 | MB1 | MB1 | MB2 | MB2 | MB1 | MB1 | MB1 | MB1 |
| | | | Amount | Parts by mass | 1 | 3 | 5 | 20 | 50 | 0.1 | 3 | 3 | 1 | 3 | 3 | 3 | 3 | 100 |
| | Layer B composition | Resin | Type | - | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet (Washing) | PPS pellet 1 | PPS pellet (Washing) |
| | | | Amount | Parts by mass | 100 | 100 | 100 | 100 | 100 | 100 | 100 | 100 | 100 | 100 | 100 | 100 | 100 | 100 |
| Washing treatment | Solvent | | | - | NMP | NMP | NMP | NMP | NMP | NMP | NMP | NMP | NMP | NMP | NMP | NMP | - | NMP |
| | Temperature | | | °C | 150 | 150 | 150 | 150 | 150 | 150 | 150 | 150 | 150 | 150 | 150 | 150 | - | 150 |
| | Time | | | h | 24 | 24 | 24 | 24 | 24 | 24 | 24 | 24 | 24 | 24 | 24 | 24 | - | 24 |
| | Fine bubble | | | - | $O_2$ | $O_2$ | $O_2$ | $O_2$ | $O_2$ | $O_2$ | $O_2$ | $O_2$ | $O_2$ | $O_2$ | - | $O_2$ | - | $O_2$ |
| Film configuration | Laminated configuration | | | | A/B/A | A/B/A | A/B/A | A/B/A | A/B/A | A/B/A | A/B/A | A/B/A | A/B/A | A/B/A | A/B/A | A/B | A/B/A | A/B/A |
| | Thickness of layer A in film | | | µm | 0.6 | 0.6 | 0.6 | 0.6 | 0.6 | 0.6 | 1.4 | 3.0 | 0.6 | 0.6 | 0.6 | 0.3 | 0.6 | 0.6 |
| | Thickness ratio of layer A | | | % | 2.4 | 2.4 | 2.4 | 2.4 | 2.4 | 2.4 | 5.6 | 12 | 2.4 | 2.4 | 2.4 | 1.2 | 2.4 | 2.4 |
| | Major axis of dispersion in layer A | | | µm | 700 | 700 | 700 | 700 | 700 | 700 | 700 | 700 | - | - | 700 | 700 | 700 | 700 |
| | Aspect ratio of dispersion in layer A | | | - | 7.2 | 7.2 | 7.2 | 7.2 | 7.2 | 7.2 | 7.2 | 7.2 | - | - | 7.2 | 7.2 | 7.2 | 7.2 |
| | Void formation ratio | | | % | 1 | 1 | 1 | 1 | 1 | 1 | 1 | 1 | 80 | 80 | 1 | 1 | 1 | 1 |
| Spectral light transmittance | Wavelength 550 nm (Ta) | | | % | 83.5 | 82.9 | 80.0 | 78.5 | 75.2 | 83.6 | 80.2 | 78.8 | 78.3 | 77.5 | 81.8 | 83.5 | 78.5 | 73.5 |
| | Wavelength 400 nm (Tb) | | | % | 76.5 | 76.0 | 75.0 | 72.5 | 68.1 | 76.6 | 74.8 | 72.1 | 70.6 | 70.0 | 74.5 | 76.5 | 71.4 | 66.1 |
| | Wavelength 600 nm (Tc) | | | % | 84.2 | 83.9 | 83.5 | 82.1 | 78.5 | 84.2 | 83.2 | 81.2 | 79.4 | 79.2 | 82.8 | 84.2 | 80.5 | 76.8 |
| Light transmittance difference Tc - Tb | | | | % | 7.7 | 7.9 | 8.5 | 9.6 | 10.4 | 7.6 | 8.4 | 9.1 | 8.8 | 9.2 | 8.3 | 7.7 | 9.1 | 10.7 |
| Color tone | b value | | | - | 1.7 | 1.9 | 2.4 | 2.9 | 3.9 | 1.6 | 2.2 | 2.5 | 2.7 | 2.9 | 2.3 | 1.7 | 3.2 | 4.8 |
| | L value | | | - | 93.2 | 93.0 | 92.8 | 91.5 | 89.2 | 93.4 | 92.8 | 92.7 | 91.0 | 89.0 | 92.9 | 93.2 | 92.1 | 86.5 |
| Surface roughness (Ra) | | | | nm | 35 | 45 | 70 | 80 | 80 | 23 | 30 | 25 | 78 | 115 | 35 | 35 | 35 | 80 |
| Presence or absence of FT-IR peak | | | | - | Presence | Presence | Presence | Presence | Presence | Presence | Presence | Presence | Absence | Absence | Presence | Presence | Presence | Presence |
| Depth volume (Vv) | | | | $µm^3$ | 380 | 350 | 330 | 330 | 330 | 480 | 380 | 450 | 350 | 360 | 340 | 340 | 380 | 330 |
| Depth volume (Vv)/number of protrusions (n) | | | | $µm^3$/number | 0.8 | 0.3 | 0.2 | 0.1 | 0.1 | 1.2 | 1.0 | 2.0 | 0.7 | 0.3 | 0.3 | 0.8 | 0.3 | 0.1 |
| Glossiness | | | | % | 170 | 170 | 165 | 150 | 150 | 175 | 175 | 175 | 120 | 100 | 170 | 170 | 170 | 150 |
| Transparency | | | | - | AA | AA | AA | A | B | AA | AA | A | A | B | AA | AA | A | C |
| Color tone | | | | - | AA | AA | A | B | C | AA | A | A | B | B | A | AA | C | C |
| Running performance | | | | - | A | A | A | A | A | A | A | A | A | A | A | A | A | A |
| Surface quality | | | | - | A | AA | AA | AA | AA | B | A | B | A | AA | AA | A | AA | AA |

[Table 2-1]

| | | | | | Example 28 | Example 29 | Example 30 | Example 31 | Example 32 | Example 33 | Example 34 | Example 35 | Example 36 | Example 37 | Example 38 | Example 39 | Comparative Example 4 |
|---|---|---|---|---|---|---|---|---|---|---|---|---|---|---|---|---|---|
| Raw material | Layer A composition | Resin | Type | - | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 |
| | | | Amount | Parts by mass | 99 | 99 | 99 | 99 | 99 | 99 | 99 | 99 | 99.9 | 96 | 99 | 99 | 93 |
| | | Masterbatch | Type | - | MB1 | MB1 | MB1 | MB1 | MB1 | MB1 | MB1 | MB1 | MB1 | MB1 | MB2 | MB3 | MB2 |
| | | | Amount | Parts by mass | 1 | 1 | 1 | 1 | 1 | 1 | 1 | 1 | 0.1 | 4 | 1 | 1 | 7 |
| | Layer B composition | Resin | Type | - | - | - | - | - | - | - | - | - | - | - | - | - | - |
| | | | Amount | Parts by mass | - | - | - | - | - | - | - | - | - | - | - | - | - |
| Washing treatment | Solvent | | | °C | NMP | NMP | NMP | NMP | NMP | NMP | NMP | NMP | NMP | NMP | NMP | NMP | NMP |
| | Temperature | | | °C | 150 | 150 | 150 | 150 | 120 | 180 | 150 | 150 | 150 | 150 | 150 | 150 | 150 |
| | Time | | | h | 24 | 24 | 12 | 6 | 24 | 24 | 24 | 24 | 24 | 24 | 24 | 24 | 24 |
| | Fine bubble | | | - | $O_2$ | - | - | - | - | - | $CO_2$ | $N_2$ | - | - | - | - | - |
| Film configuration | Laminated configuration | | | | Only layer A | Only layer A | Only layer A | Only layer A | Only layer A | Only layer A | Only layer A | Only layer A | Only layer A | Only layer A | Only layer A | Only layer A | Only layer A |
| | Thickness of layer A in film | | | μm | 25 | 25 | 25 | 25 | 25 | 25 | 25 | 25 | 25 | 25 | 25 | 25 | 25 |
| | Thickness ratio of layer A | | | % | 100 | 100 | 100 | 100 | 100 | 100 | 100 | 100 | 100 | 100 | 100 | 100 | 100 |
| | Major axis of dispersion in layer A | | | nm | 700 | 700 | 700 | 700 | 700 | 700 | 700 | 700 | 700 | 700 | - | 1400 | - |
| | Aspect ratio of dispersion in layer A | | | - | 7.2 | 7.2 | 7.2 | 7.2 | 7.2 | 7.2 | 7.2 | 7.2 | 7.2 | 7.2 | - | 10.5 | - |
| | Void formation ratio | | | % | 1 | 1 | 1 | 1 | 1 | 1 | 1 | 1 | 1 | 1 | 80 | 1 | 80 |
| Spectral light transmittance | Wavelength 550 nm (Ta) | | | % | 83.2 | 81.5 | 81.2 | 79.3 | 79.5 | 81.0 | 81.3 | 81.2 | 81.6 | 78.6 | 76.3 | 79.4 | 73.9 |
| | Wavelength 400 nm (Tb) | | | % | 76.3 | 73.9 | 73.5 | 72.2 | 71.0 | 73.2 | 74.4 | 74.3 | 74.2 | 71.4 | 68.6 | 73.2 | 65.1 |
| | Wavelength 600 nm (Tc) | | | % | 84.0 | 82.5 | 82.1 | 81.0 | 80.7 | 82.2 | 82.6 | 82.5 | 82.8 | 80.2 | 77.8 | 82.1 | 76.4 |
| Light transmittance difference Tc - Tb | | | | % | 7.7 | 8.6 | 8.6 | 8.8 | 9.7 | 9.0 | 8.2 | 8.2 | 8.6 | 8.8 | 9.2 | 8.9 | 11.3 |
| Color tone | b value | | | - | 1.7 | 2.1 | 2.6 | 2.7 | 2.8 | 2.6 | 2.1 | 2.3 | 2.2 | 2.7 | 2.9 | 2.5 | 5.0 |
| | L value | | | - | 92.1 | 92.0 | 91.8 | 91.6 | 91.5 | 91.4 | 91.8 | 91.9 | 92.3 | 90.7 | 90.5 | 92.6 | 88.5 |
| Surface roughness (Ra) | | | | nm | 25 | 25 | 25 | 25 | 25 | 25 | 25 | 25 | 17 | 40 | 40 | 35 | 75 |
| Presence or absence of FT-IR peak | | | | - | Presence | Presence | Presence | Presence | Presence | Presence | Presence | Presence | Presence | Presence | Absence | Presence | Absence |
| Depth volume (Vv) | | | | μm³ | 540 | 540 | 540 | 540 | 540 | 540 | 540 | 540 | 750 | 340 | 380 | 650 | 320 |
| Depth volume (Vv)/number of protrusions (n) | | | | μm³/number | 1.2 | 1.2 | 1.2 | 1.2 | 1.2 | 1.2 | 1.2 | 1.2 | 2.8 | 0.8 | 0.7 | 1.5 | 0.7 |
| Glossiness | | | | % | 175 | 175 | 175 | 175 | 175 | 175 | 175 | 175 | 175 | 170 | 130 | 170 | 130 |
| Transparency | | | | - | AA | AA | AA | A | A | AA | AA | AA | AA | A | B | A | C |
| Color tone | | | | - | AA | A | B | B | B | B | AA | AA | A | B | B | A | C |
| Running performance | | | | - | A | A | A | A | A | A | A | A | B | A | A | A | A |
| Surface quality | | | | - | B | B | B | B | B | B | B | B | C | A | A | B | A |

[Table 2-2]

| | | | | | Example 40 | Example 41 | Example 42 | Example 43 | Example 44 | Example 45 | Example 46 | Example 47 | Example 48 | Example 49 | Example 50 | Example 51 | Comparative Example 5 |
|---|---|---|---|---|---|---|---|---|---|---|---|---|---|---|---|---|---|
| Raw material | Layer A composition | Resin | Type | - | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | - |
| | | | Amount | Parts by mass | 99 | 97 | 95 | 80 | 50 | 99.9 | 97 | 97 | 99 | 97 | 97 | 97 | - |
| | | Masterbatch | Type | - | MB1 | MB1 | MB1 | MB1 | MB1 | MB1 | MB1 | MB1 | MB2 | MB2 | MB1 | MB1 | MB1 |
| | | | Amount | Parts by mass | 1 | 3 | 5 | 20 | 50 | 0.1 | 3 | 3 | 1 | 3 | 3 | 3 | 100 |
| | Layer B composition | Resin | Type | - | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 | PPS pellet 1 |
| | | | Amount | Parts by mass | 100 | 100 | 100 | 100 | 100 | 100 | 100 | 100 | 100 | 100 | 100 | 100 | 100 |
| ashing treatment | Solvent | | | °C | NMP | NMP | NMP | NMP | NMP | NMP | NMP | NMP | NMP | NMP | NMP | NMP | NMP |
| | Temperature | | | °C | 150 | 150 | 150 | 150 | 150 | 150 | 150 | 150 | 150 | 150 | 150 | 150 | 150 |
| | Time | | | h | 24 | 24 | 24 | 24 | 24 | 24 | 24 | 24 | 24 | 24 | 24 | 24 | 24 |
| | Fine bubble | | | - | $O_2$ | $O_2$ | $O_2$ | $O_2$ | $O_2$ | $O_2$ | $O_2$ | $O_2$ | $O_2$ | $O_2$ | - | $O_2$ | $O_2$ |
| Film configuration | Laminated configuration | | | | A/B/A | A/B/A | A/B/A | A/B/A | A/B/A | A/B/A | A/B/A | A/B/A | A/B/A | A/B/A | A/B/A | A/B | A/B/A |
| | Thickness of layer A in film | | | μm | 0.6 | 0.6 | 0.6 | 0.6 | 0.6 | 0.6 | 1.4 | 3 | 0.6 | 0.6 | 0.6 | 0.3 | 0.6 |
| | Thickness ratio of layer A | | | % | 2.4 | 2.4 | 2.4 | 2.4 | 2.4 | 2.4 | 5.6 | 12 | 2.4 | 2.4 | 2.4 | 1.2 | 2.4 |
| | Major axis of dispersion in layer A | | | nm | 700 | 700 | 700 | 700 | 700 | 700 | 700 | 700 | - | - | 700 | 700 | 700 |
| | Aspect ratio of dispersion in layer A | | | - | 7.2 | 7.2 | 7.2 | 7.2 | 7.2 | 7.2 | 7.2 | 7.2 | - | - | 7.2 | 7.2 | 7.2 |
| | Void formation ratio | | | % | 1 | 1 | 1 | 1 | 1 | 1 | 1 | 1 | 80 | 80 | 1 | 1 | 1 |
| Spectral light transmittance | Wavelength 550 nm (Ta) | | | % | 83.6 | 83.0 | 80.1 | 78.5 | 75.3 | 83.5 | 80.2 | 78.9 | 78.5 | 77.6 | 81.7 | 83.5 | 73.6 |
| | Wavelength 400 nm (Tb) | | | % | 76.6 | 76.1 | 75.1 | 72.5 | 68.2 | 76.5 | 74.8 | 72.2 | 70.8 | 70.1 | 74.4 | 76.5 | 66.2 |
| | Wavelength 600 nm (Tc) | | | % | 84.3 | 84.0 | 83.6 | 82.1 | 78.6 | 84.1 | 83.2 | 81.3 | 79.6 | 79.3 | 82.7 | 84.2 | 76.9 |
| Light transmittance difference Tc - Tb | | | | % | 7.7 | 7.9 | 8.5 | 9.6 | 10.4 | 7.6 | 8.4 | 9.1 | 8.8 | 9.2 | 8.3 | 7.7 | 10.7 |
| Color tone | b value | | | - | 1.7 | 1.9 | 2.4 | 2.9 | 3.9 | 1.6 | 2.2 | 2.5 | 2.7 | 2.9 | 2.3 | 1.7 | 4.5 |
| | L value | | | - | 93.2 | 93.1 | 92.8 | 91.6 | 89.5 | 93.4 | 92.6 | 92.5 | 90.9 | 89.5 | 93.0 | 93.2 | 86.3 |
| Surface roughness (Ra) | | | | nm | 35 | 45 | 70 | 80 | 80 | 23 | 30 | 25 | 78 | 115 | 35 | 35 | 80 |
| Presence or absence of FT-IR peak | | | | - | Presence | Presence | Presence | Presence | Presence | Presence | Presence | Presence | Absence | Absence | Presence | Presence | Presence |
| Depth volume (Vv) | | | | $μm^3$ | 380 | 350 | 330 | 330 | 330 | 480 | 380 | 450 | 350 | 360 | 340 | 340 | 330 |
| Depth volume (Vv)/number of protrusions (n) | | | | $μm^3$/number | 0.8 | 0.3 | 0.2 | 0.1 | 0.1 | 1.2 | 1.0 | 2.0 | 0.7 | 0.3 | 0.3 | 0.8 | 0.1 |
| Glossiness | | | | % | 170 | 170 | 165 | 150 | 150 | 175 | 175 | 175 | 120 | 100 | 170 | 170 | 150 |
| Transparency | | | | - | AA | AA | AA | A | B | AA | AA | A | A | B | AA | AA | C |
| Color tone | | | | - | AA | AA | A | B | C | AA | A | A | B | B | A | AA | C |
| Running performance | | | | - | A | A | A | A | A | A | A | A | A | A | A | A | A |
| Surface quality | | | | - | A | AA | AA | AA | AA | B | A | B | A | AA | AA | A | AA |

INDUSTRIAL APPLICABILITY

The polyarylene sulfide film according to the present invention is excellent in transparency and color tone, and thus can be suitably used as a transparent circuit substrate and a transparent antenna substrate.

## Claims

1. A polyarylene sulfide film comprising a polyarylene sulfide (PAS) based resin as a main component, having a spectral light transmittance Ta of 75% or more at a wavelength of 550 nm and a b value of 5.0 or less.

2. The polyarylene sulfide film according to claim 1, wherein the b value is 3.0 or less.

3. The polyarylene sulfide film according to claim 1 or 2, wherein a spectral light transmittance Tb at a wavelength of 400 nm and a spectral light transmittance Tc at a wavelength of 600 nm satisfy the following formula (i) :

$$Tc - Tb \leq 8.2\% \quad \text{Formula (i)}$$

4. The polyarylene sulfide film according to any of claims 1 to 3, wherein at least one film surface has a surface roughness (Ra) of 10 nm or more and 200 nm or less.

5. The polyarylene sulfide film according to any of claims 1 to 4, wherein a depth volume (Vv) from a reference surface on at least one film surface is 50 $\mu m^3$ or more and 800 $\mu m^3$ or less.

6. The polyarylene sulfide film according to any of claims 1 to 5, wherein a depth volume (Vv) and the number of protrusions (n) from a reference surface on at least one film surface satisfy the following formula (iii):

$$0.01 \leq Vv/n \leq 3.0 \quad \text{Formula (iii)}$$

7. The polyarylene sulfide film according to any of claims 1 to 6, wherein at least one film surface has a glossiness of 140% or more and less than 200%.

8. The polyarylene sulfide film according to any of claims 1 to 7, comprising particles and/or a dispersion, wherein the particles and the dispersion have a void formation ratio of 10% or less.

9. The polyarylene sulfide film according to any of claims 1 to 8, wherein the polyarylene sulfide film has at least one absorption peak between 1145 $cm^{-1}$ and 1160 $cm^{-1}$ in an infrared absorption spectrum obtained by Fourier transform infrared spectroscopy (FT-IR).

10. The polyarylene sulfide film according to any of claims 1 to 9, comprising two or more layers mainly containing a polyarylene sulfide-based resin as a main component, wherein at least one outermost layer is a layer (layer A) containing the polyarylene sulfide-based resin as a main component and containing at least one thermoplastic resin (X) that is different from the polyarylene sulfide resin.

11. The polyarylene sulfide film according to any of claims 1 to 9, comprising three or more layers mainly containing a polyarylene sulfide-based resin as a main component, wherein both outermost layers are layers (layers A) containing the polyarylene sulfide-based resin as a main component and containing at least one thermoplastic resin (X) that is different from the polyarylene sulfide-based resin.

12. The polyarylene sulfide film according to claim 10 or 11, wherein the layer A has at least one absorption peak between 1145 $cm^{-1}$ and 1160 $cm^{-1}$ in an infrared absorption spectrum obtained by Fourier transform infrared spectroscopy (FT-IR).

13. The polyarylene sulfide film according to any of claims 10 to 12, wherein the thermoplastic resin (X) that is different from the polyarylene sulfide is incompatible with the polyarylene sulfide-based resin, and the thermoplastic resin (X) that is different from the polyarylene sulfide is contained as a dispersion in the polyarylene sulfide-based resin.

**14.** The polyarylene sulfide film according to claim 13, wherein the dispersion has an aspect ratio of 5.0 or more and 15.0 or less, and the dispersion has a major axis of 200 to 2000 nm.

**15.** The polyarylene sulfide film according to any of claims 10 to 14, wherein the layer A has a thickness ratio of 0.1% or more and 10% or less with respect to a total thickness of the film.

**16.** The polyarylene sulfide film according to any of claims 1 to 15, which is used for a transparent circuit substrate.

**17.** The polyarylene sulfide film according to any of claims 1 to 15, which is used for a transparent antenna substrate.

**INTERNATIONAL SEARCH REPORT**

International application No.
**PCT/JP2021/034504**

**A. CLASSIFICATION OF SUBJECT MATTER**

***C08J 5/18***(2006.01)i; ***H01Q 1/38***(2006.01)i; ***H05K 1/03***(2006.01)i
FI: C08J5/18 CEZ; H05K1/03 610H; H01Q1/38

According to International Patent Classification (IPC) or to both national classification and IPC

**B. FIELDS SEARCHED**

Minimum documentation searched (classification system followed by classification symbols)

C08J5/18; H01Q1/38; H05K1/03

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2013-67748 A (TORAY IND., INC.) 18 April 2013 (2013-04-18)<br>claims, paragraphs [0041]-[0044], [0052] | 1, 16-17<br>2-15 |
| A | JP 2017-88690 A (TOSOH CORP.) 25 May 2017 (2017-05-25)<br>claims, paragraph [0070] | 1-17 |
| A | JP 2009-138206 A (KUREHA CORP.) 25 June 2009 (2009-06-25) | 1-17 |
| A | JP 2011-89110 A (TORAY IND., INC.) 06 May 2011 (2011-05-06)<br>paragraphs [0077]-[0079], [0082]-[0085], comparative example 1 | 1-17 |
| A | JP 2004-153206 A (TORAY IND., INC.) 27 May 2004 (2004-05-27)<br>claims, paragraph [0026] | 1-17 |
| A | JP 2004-231909 A (TORAY IND., INC.) 19 August 2004 (2004-08-19)<br>claims, paragraph [0018] | 1-17 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 November 2021** | **07 December 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br><br>Telephone No. |

Form PCT/ISA/210 (second sheet) (January 2015)

**INTERNATIONAL SEARCH REPORT**
**Information on patent family members**

International application No.
**PCT/JP2021/034504**

| Patent document cited in search report | Publication date (day/month/year) | Patent family member(s) | Publication date (day/month/year) |
|---|---|---|---|
| JP 2013-67748 A | 18 April 2013 | (Family: none) | |
| JP 2017-88690 A | 25 May 2017 | (Family: none) | |
| JP 2009-138206 A | 25 June 2009 | US 2006/0084785 A1<br>WO 2004/060972 A1<br>EP 1577336 A1<br>CN 1732211 A<br>KR 10-2005-0087858 A | |
| JP 2011-89110 A | 06 May 2011 | (Family: none) | |
| JP 2004-153206 A | 27 May 2004 | (Family: none) | |
| JP 2004-231909 A | 19 August 2004 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013067748 A
- JP 2009138206 A
- JP 453368 B
- JP 2007021343 A